# EUROPEAN PATENT SPECIFICATION

(11) **EP 1 835 543 B1**
(45) Date of publication and mention of the grant of the patent: **09.05.2018**
(21) Application number: 06005196.8
(22) Date of filing: 14.03.2006
(51) Int. Cl.: H01L 29/78, H01L 21/336, H01L 29/267, H01L 29/772, H01L 29/16

(54) **Method for manufacturing a semiconductor device**
Methode zur Herstellung eines Halbleiterbauelements
Méthode de fabrication d'un dispositif semi-conducteur

(43) Date of publication of application: 19.09.2007
(73) Proprietor: NISSAN MOTOR CO., LTD., Yokohama-shi, Kanagawa-ken (JP)
(72) Inventor: Hayashi, Tetsuya, Yokosuka-shi Kanagawa-ken (JP); Hoshi, Masakatsu, Yokohama-shi Kanagawa-ken (JP); Shimoida, Yoshio, Yokosuka-shi Kanagawa-ken (JP); Tanaka, Hideaki, Yokohama-shi Kanagawa-ken (JP)
(74) Representative: Grünecker Patent- und Rechtsanwälte PartG mbB

(56) References cited:
- US-A- 5 977 564
- PATENT ABSTRACTS OF JAPAN vol. 2003, no. 12, 5 December 2003 (2003-12-05) -& JP 2005 259796 A (NISSAN MOTOR CO LTD), 22 September 2005 (2005-09-22)

## Description

The present invention relates to a method of manufacturing a semiconductor device.

As the related art which is the background of the present invention, Japanese Patent Application Publication No. 2003-318398 filed by the applicant of the present invention has been disclosed. In this related art, an N' type polycrystalline silicon region and an N⁺ type polycrystalline silicon region are formed so as to adjoin each other on one main surface of a semiconductor body in which an N' type silicon carbide epitaxial region is formed on an N⁺ type silicon carbide substrate, in addition, the epitaxial region, the N⁻ type polycrystalline silicon region and the N⁺ type polycrystalline silicon region forms a hetero junction. Furthermore, a gate electrode is formed so as to be adjacent to a junction portion between the epitaxial layer, and the N⁺ type polycrystalline silicon region while interposing a gate insulating film therebetween. The N⁻ type polycrystalline silicon region is connected to a source electrode, and a drain electrode is formed on a backside surface of the N⁺ type silicon carbide substrate.

The semiconductor device of the related art having the structure as described above functions as a switching device by controlling an electric potential of the gate electrode in a state where the source electrode is grounded and a predetermined positive electric potential is applied to the drain electrode. That is, in the state where the gate electrode is grounded, reverse bias is applied to the hetero junction formed of the N' type polycrystalline silicon region, the N⁺ type polycrystalline silicon region and the epitaxial region so that no current flows between the drain electrode and the source electrode. However, in the state where the predetermined positive voltage is applied to the gate electrode, gate electric filed acts on a hetero junction interface between the N⁺ type polycrystalline silicon region and the epitaxial region, and an energy barrier formed by the hetero junction surface on a gate oxide film interface is made to be thin. Therefore, current flows between the drain electrode and the source electrode. In this related art, since the hetero junction portion is used as a control channel for cutting-off and flowing of the current, the device functions with a channel length having a thickness equal to that of the hetero barrier. Therefore, a conduction characteristic of low resistance can be obtained.

JP 2005 259796 A describes a semiconductor device which includes a first conductivity type drain region, a first hetero semiconductor region and a second semiconductor region that contact one main surface of the drain region and has a different band-gap from that of the drain region, a gate electrode formed on a junction between the first hetero semiconductor region and the drain region via a gate dielectric, a source electrode connected to the first hetero semiconductor region and the second hetero semiconductor region; and a drain electrode connected to the drain region. The respective conductivity types of the two hetero semiconductor regions are opposite to one another. However, in the related art, driving force is lowered because damages are caused on an etching surface of the silicon carbide epitaxial region when a physical etching such as a dry etching is used at the time of patterning the polycrystalline silicon region formed on the silicon carbide epitaxial region to form a channel interface between the polycrystalline silicon region and the silicon carbide epitaxial region.

The present invention has been made to solve the above problems of the related art. Accordingly, it is an objective of the present invention to provide a method of manufacturing a semiconductor device capable of suppressing decrease of the driving force.

According to a first method aspect of the present invention, said objective is solved by a method of manufacturing of a semiconductor device according to the technical teaching of independent claim 1.

According to a second method aspect of the present invention, the aforementioned objective is solved by a method of manufacturing a semiconductor device according to the technical teaching of independent claim 6.

Preferred embodiments of the present invention are laid down in the respective subclaims.

In the following, the present invention is explained in greater detail by means of several embodiments thereof in conjunction with the accompanying drawings, wherein:
FIG. 1 is a cross sectional diagram showing a semiconductor device according to a first embodiment;
FIGS. 2A to 2H are cross sectional diagrams showing a method of manufacturing a silicon carbide semiconductor device according to the first embodiment shown in FIG. 1;
FIG. 3 is a cross sectional diagram showing a structure that is different from FIG. 1 in that a hetero semiconductor region 3 is flatly formed;
FIGS. 4A to 4B are cross sectional diagrams showing a method of manufacturing a semiconductor device shown in FIG. 3;
FIGS. 5A to 5F are cross sectional diagrams showing another method of manufacturing semiconductor device show in FIG. 3;
FIG. 6 is a cross sectional diagram showing a structure that is different from FIG. 1 in that a hetero semiconductor region 3 (N⁻type polycrystalline silicon) and a second hetero semiconductor region 12 (P⁻type polycrystalline silicon) are formed;
FIG. 7 is a cross sectional diagram showing a structure that is different from FIG. 1 in that N⁺ type conducting region 13 having higher concentration than that of a drain region 2 is formed;
FIG. 8 is a cross sectional diagram showing a structure, in addition to the structure of FIG. 1, an electric field relaxation region 14 is formed on a surface of a drain region 2; and
FIG. 9 is a cross sectional diagram showing a modified example of the structure of FIG. 1.

Detailed description of preferred embodiments will be given below by referring to the accompanying drawings. It should be noted that the same reference numerals are used in the following drawings among the components having same function, and the same description is not repeated.

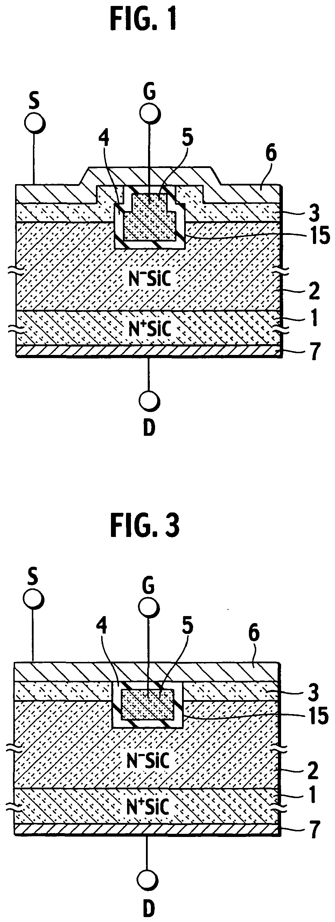

FIG. 1 shows a first embodiment of a semiconductor device according to the technical teaching. FIG 1 is a cross sectional diagram of two structural unit cells facing each other. In the present embodiment, the description is given as one example by using a semiconductor device whose substrate material is silicon carbide (SiC).

For example, a drain region 2 formed of an N⁻ type silicon carbide epitaxial layer is formed on a substrate 1 formed of N⁺ type silicon carbide in which polytype is 4H and a hetero semiconductor region 3 formed of, for example, N type polycrystalline silicon is formed so as to adjoin a main surface of the drain region 2 opposing to a junction surface with the substrate 1. That is, the junction portion between the drain region 2 and the hetero semiconductor region 3 is composed of a hetero junction formed of materials of silicon carbide and polycrystalline silicon which are different in a band gap, and an energy barrier is present on a junction interface thereof. A gate insulating film 4 formed of, for example, a silicon oxide film is formed so as to adjoin the junction portion between the hetero semiconductor region 3 and the drain region 2. In addition, a gate electrode 5 is formed on the gate insulating film 4, and a source electrode 6 is formed on the surface of the hetero semiconductor region 3 opposite to the junction surface between the hetero semiconductor region 3 and the drain region 2, and a drain electrode 7 is formed on the substrate 1 so as to be connected to the substrate 1. In the present embodiment, as shown in FIG. 1, a trench 15 is formed in the drain region 2 so that a trench type structure in which the gate electrode 5 is buried is obtained.

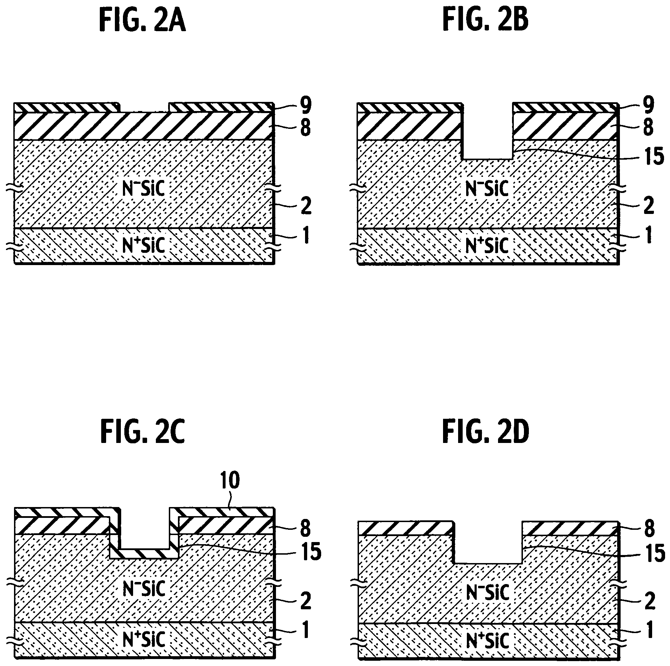

A method of manufacturing a silicon carbide semiconductor device according to the first embodiment shown FIG. 1 will now be described by referring to FIGS. 2A to 2H.

First, as shown in FIG. 2A, a nitride silicon film is deposited on an N type silicon carbide semiconductor body formed by epitaxialy growing the N⁻ type drain region 2 on the N⁺ type silicon carbide substrate 1. The silicon nitride film serves as an antioxidant film (mask layer) 8 and is formed by, for example, a Low Pressure-Chemical Vapor Deposition (LP-CVD) method. Further, a mask layer 9 having a predetermined opening is formed on the antioxidant film 8 formed of the nitride silicon film by photolithography and etching.

As shown in FIG. 2B, by using the mask layer 9 as a mask, the antioxidant film 8 and a surface layer portion of the drain region 2 are etched by using, for example, reactive ion etching (dry etching), and the drain region 2 is etched by a predetermined depth so that a trench 15 is formed. It should be noted that as a method of etching the antioxidant film 8 formed of the nitride silicon film and the drain region 2, other method may be used as long as it is an anisotropic etching.

As shown in FIG. 2C, since etching damages are caused in the etched drain region 2 by dry etching, sacrificial oxidation is carried out by, for example, dry O₂ oxidation at 1100°C to remove the damages, thus forming a sacrificial oxide film 10. At this time, in the present embodiment, since the nitride silicon film is formed by the LP-CVD method to be used as the antioxidant film 8, an oxidation rate thereof is relatively close to that of the drain region 2 formed of silicon carbide. Therefore, the sacrificial oxide film 10 at the same level is formed also on the antioxidant film 8 of the nitride silicon film. Thus, an upper end portion of the side wall of the drain region 2 and an end portion of the antioxidant film 8 can be kept to be flush. It should be noted that as a method of forming the sacrificial oxide film 10, the oxidation using the dry O₂ oxidation is given as one example, but any method may be used as long as the region damaged by etching in the drain region 2 can be buried into the oxide film.

As shown in FIG. 2D, the sacrificial oxide film 10 (FIG. 2C) is removed by wet etching by use of a mixed solution of, for example, ammonium fluoride and hydrofluoric acid.

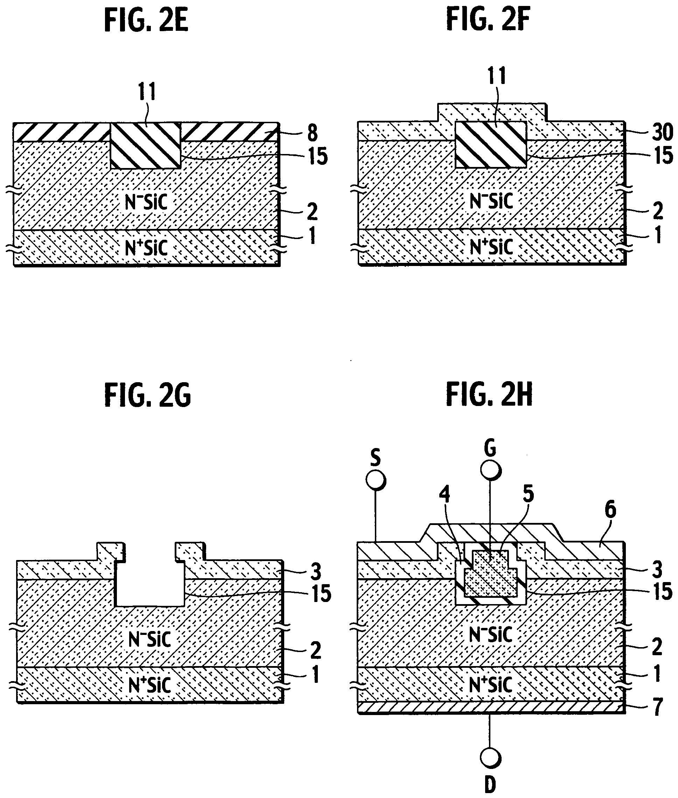

As shown in FIG. 2E, a buried region 11 is formed by using a reflowable material such as Spin-On-Glass (SOG). In the present embodiment, there is shown a case where the buried region 11 is formed so as to be substantially flush with the upper end portion of the trench 15 while including the trench in the antioxidant film 8. However, as long as the trench 15 is formed so as to adjoin at least the junction interface between the drain region 2 and the antioxidant film 8, there is no problem in that it is not completely buried, or extended from the trench to the outside. In addition, at the time of forming the buried region 11, a material for the buried region may also be formed on the antioxidant film 8, and then the buried region is formed by etchback.

As shown in FIG. 2F, after the antioxidant film 8 formed of nitride silicon is removed by, for example, a phosphate solution, polycrystalline silicon is deposited by, for example, the LP-CVD method. After that, phosphorus doping is carried out in the atmosphere of, for example, phosphoryl chloride (POCl₃) so that a hetero semiconductor layer 30 formed of N type polycrystalline silicon is formed. It should be noted that this polycrystalline silicon layer may be formed by laser annealing, or the like to recrystallize it after being deposited by the electronic beam evaporation method or the sputtering method, or may be formed of single crystalline silicon of hetero epitaxial growth by, for example, the molecular beam epitaxy. In addition, for the doping of the polycrystalline silicon layer, a combination of ionic implantation and activation heat treatment after the ionic implantation may be used.

As shown in FIG. 2G, a mask layer (not shown) having a predetermined opening is formed in a predetermined region of the hetero semiconductor layer 30 of polycrystalline silicon by the photolithography and the etching, and one portion of the hetero semiconductor layer 30 is etched by, for example, reactive ion etching (dry etching) so that a hetero semiconductor region 3 is formed. Then, for example, the buried region 11 (FIG. 2F) formed of oxide is subjected to wet etching by a mixed solution of, for example, ammonium fluoride and hydrofluoric acid.

Lastly, as shown in FIG. 2H, a gate insulating film 4 is deposited along the inner wall of the hetero semiconductor region 3 and the drain region 2. Further, a polycrystalline silicon layer to be a gate electrode 5 is deposited. After that, phosphorus is doped into the polycrystalline silicon layer to be the gate electrode 5 by solid phase diffusion using POCl₃. After that, the gate electrode 5 is formed by the photolithography, etching, or the like before a drain electrode 7 formed of, for example, titanium (Ti) and nickel (Ni) is formed on the substrate 1 corresponding to a backside surface of the semiconductor device, and a source electrode 6 (insulated from the gate electrode 5 by the insulating film) formed by sequentially depositing titanium (Ti) and nickel (Ni) is formed in the hetero semiconductor region 3 corresponding to a front surface of the semiconductor device. Thus, the silicon carbide semiconductor device according to the first embodiment shown in FIG. 1 is completed. It should be noted that, in the present embodiment, the case where the gate electrode 5 is buried in the trench is given as one example, but it may be formed so as to extend onto the hetero semiconductor region 3 through the gate insulating film 4. In addition, there is given one example that the neighboring regions are connected each other in such a manner that the source electrode 6 covers the gate electrode through the insulating film, but they do not have to be connected.

As described above, the present embodiment has a structure where, in a method of manufacturing a semiconductor device including a semiconductor body of a first conductivity type (a substrate 1 and a drain region 2), a hetero semiconductor region 3 adjacent to one main surface of the semiconductor body and having a band gap different from that of the semiconductor body, a gate electrode 5 formed in a junction portion between the hetero semiconductor region 3 and the semiconductor body through a gate insulating film 4, a source electrode 6 connected to the hetero semiconductor region 3, and a drain electrode 7 having an ohmic connection with the semiconductor body, the method of manufacturing the semiconductor device includes at least a first process of forming a predetermined trench 15 on the main surface side of the semiconductor body by using a mask layer 9 having a predetermined opening, a second process of forming a buried region 11 so as to adjoin at least a side wall of the trench 15 and extend from the trench 15, a third process of forming a hetero semiconductor layer 30 so as to adjoin the semiconductor body and the buried region 11, and a fourth process of forming the hetero semiconductor region 3 by patterning the hetero semiconductor layer 30.

With this structure, the semiconductor device according to the present embodiment can be easily obtained with an earlier manufacturing technique. In addition, with this manufacturing method, a structure in which an upper end portion of the trench 15 of the drain region 2 with etching damage removed comes to be a substantially flush with an end portion of the hetero semiconductor region 3 can be easily formed. With this, the gate electrode 5 can be formed through the gate insulating film 4 so as to oppose substantially perpendicular to a junction interface between the drain region 2 and the hetero semiconductor region 3. Therefore, an electric field effectively expands to the hetero junction interface depending on a voltage applied to the gate electrode 5 and driving force during conduction is improved. In addition, by using a nitride silicon film as an antioxidant film 8, in the present embodiment in which the drain region 2 is formed of silicon carbide, the upper end portion of the trench 15 in the drain region 2 can be further easily formed to be substantially flush with the end portion of the hetero semiconductor region 3.

In addition, in the fourth process, the hetero semiconductor region 3 may be formed by etching back the hetero semiconductor layer 30. With this, the source electrode 6 can be formed on a flat surface so that reliability of the semiconductor device is improved.

As the buried region 11 is formed of a material which is removable after the third process, the manufacturing processes come to be easy. That is, a material which is easily etched by wet etching and has a relatively large selection ratio to the drain region 2 and the hetero semiconductor region 3 is used for the buried region 11. Therefore, the manufacturing processes come to be easy.

After the fourth process, a process of forming the gate insulating film 4 so as to adjoin the hetero interface between the hetero semiconductor region 3 and the semiconductor body is included. With this, it is possible to provide a hetero junction insulated gate field effect transistor with easy manufacturing processes.

Between the first process and the second process, a process of sacrificial oxidation is included. With this, a structure in which the upper end portion of the trench 15 in the drain region 2 comes to be substantially flush with the end portion of the hetero semiconductor region 3 while etching damages are removed can be easily formed. Thus, the gate electrode 5 can be formed through the gate insulating film 4 so as to oppose substantially perpendicular to the junction interface between the drain region 2 and the hetero semiconductor region 3. Therefore, an electric field effectively expands to the hetero junction interface depending on a voltage applied to the gate electrode 5 so that driving force during conduction is improved.

Meanwhile, the semiconductor body is formed of silicon carbide. With this, a semiconductor with a high break down voltage can be easily obtained by using a general semiconductor material.

Furthermore, the hetero semiconductor region 3 is formed of at least one of single crystalline silicon, polycrystalline silicon, and amorphous silicon. With this, a semiconductor device can be easily obtained by using a general semiconductor material.

In addition, the antioxidant film 8 of the mask layer is formed of a material having a similar value to that of a thermal oxidation rate of silicon carbide. With this, a sacrificial oxide film 10 at the same level is formed also on the antioxidant film 8 of the nitride silicon film. Therefore, the upper end portion of the side wall of the drain region 2 and the end portion of the antioxidant film 8 can retain to be substantially flush with each other.

Next, operations will be described. In the present embodiment, for example, the source electrode 6 is grounded and a positive potential is applied to the drain electrode 7.

First, when the gate electrode 5 is, for example, grounded or is a negative potential, a shielding state is kept. It is because that energy barrier is formed to conduction electron on both sides of the hetero junction interface between the hetero semiconductor region 3 and the drain region 2.

Next, when a positive potential is applied to the gate electrode 5 so that the shielding state is changed to a conduction state, a gate electric field reaches the hetero junction interface in which the hetero semiconductor region 3 and the drain region 2 are adjacent through the gate insulating film 4. Therefore, an accumulation layer of conduction electron is formed in the hetero semiconductor region 3 and the drain region 2 that are in the vicinity of the gate electrode 5. That is, a potential on the side of the hetero semiconductor region 3 in the junction interface between the hetero semiconductor region 3 and drain region 2 that are in the vicinity of the gate electrode 5 is depressed, and the energy barrier on the drain region 2 side comes to be precipitous. Therefore, it is possible that the conduction electron conducts through the energy barriers. In this time, by using this manufacturing method, a structure in which the upper end portion of the trench 15 in the drain region 2 with the etching damages removed comes to be substantially flush with the end portion of the hetero semiconductor region 3 can be easily formed. With this, the gate electrode 5 can be formed through the gate insulating film 4 so as to oppose substantially perpendicular to the junction interface between the drain region 2 and the hetero semiconductor region 3. Therefore, the electric filed effectively expands to the hetero junction interface depending on a voltage applied to the gate electrode 5 so that high driving force can be obtained.

Next, when the gate electrode 5 is grounded again so as to change the conducting state to the shielding state, the accumulation state of the conduction electron formed in the hetero junction interface between the hetero semiconductor region 3 and the drain region 2 is relieved, and then tunneling in the energy barrier stops. Consequently, the flow of the conduction electron from the hetero semiconductor region 3 to the drain region 2 stops. Further, the conduction electron in the drain region 2 flows to the substrate 1, and when the conduction electron is depleted, a depletion layer expands from the hetero junction portion to the drain region 2 side, resulted in the shielding state.

In addition, in this structure, similar to the structure of earlier technique, reverse direction conduction (reflux operation) is possible in which, for example, the source electrode 6 is grounded and a negative potential is applied to the drain electrode 7.

For example, when the source electrode 6 and the gate electrode 5 are grounded and a predetermined electric potential is applied to the drain electrode 7, the energy barrier for the conduction electron disappears, and the conduction electron flows from the drain region 2 side to the hetero semiconductor region 3, resulted in a reverse conduction state. In this time, a positive hole is not infused, and conduction is carried out only by the conduction electron. Therefore, loss of the conduction electron due to reverse recovery current is small at the time of changing the reverse conduction state to the shielding state. It should be noted that a case where the above described gate electrode 5 is used as a control electrode without being grounded is also possible.

A structure of FIG. 3 is different when compared with the structure of FIG. 1 in that a hetero semiconductor region 3 is flatly formed, a gate insulating film 4 is formed on a side wall of a trench 15, a gate electrode 5 is buried to be flat in the trench 15, and a source electrode 6 is flatly formed on a surface of an element.

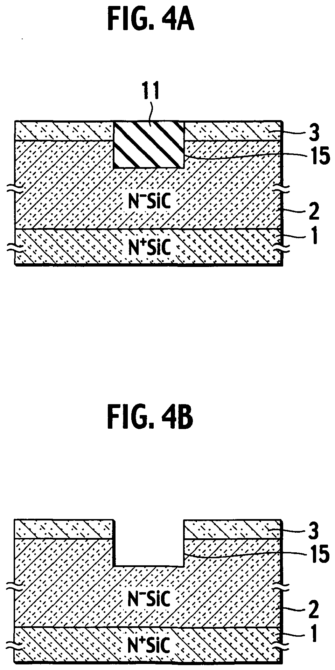

Next, a method of manufacturing a semiconductor device of silicon carbide having the structure shown in FIG. 3 will be described by referring to FIGS. 4A to 4B.

First, FIGS. 2A to 2F showing manufacturing processes of the structure of FIG. 1 have the same structure with that of FIG. 3. In the structure shown in FIG. 2F, the hetero semiconductor region 3 is processed to be flat by Chemical Mechanical Polishing (CMP), and as shown in FIG. 4A, a surface including the hetero semiconductor region 3 and a buried region 11 is flatly formed.

Next, for example, the buried region 11 formed of oxidant is subjected to wet etching by a mixed solution of, for example, ammonium fluoride and hydrofluoric acid so as to be a state shown in FIG. 4B.

Lastly, as shown in FIG. 3, similar to the structure of FIG. 1, a gate insulating film 4 is deposited along an inner wall of the hetero semiconductor region 3 and a drain region 2. Further, a polycrystal layer to be the gate electrode 5 is deposited. After that, phosphorus is doped into the polycrystalline silicon layer to be the gate electrode 5 by solid phase diffusion using POCl₃. Consequently, the gate electrode 5 is formed by the photolithography, etching, or the like before a drain electrode 7 formed of, for example, titanium (Ti) and nickel (Ni) is formed on a substrate 1 corresponding to a backside surface of the semiconductor device, and a source electrode 6 (insulated from the gate electrode 5 by the insulating film) formed by sequentially depositing titanium (Ti) and nickel (Ni) is formed in the hetero semiconductor region 3 corresponding to a front surface of the semiconductor device. Thus, the silicon carbide semiconductor device according to the structure of the embodiment shown in FIG. 3 is completed. It should be noted that, also in the present embodiment, similar to FIG. 1, the case where the gate electrode 5 is buried in the trench is given as one example, but it may be formed through the gate insulating film 4 so as to extend onto the hetero semiconductor region 3. In addition, there is given one example that the neighboring regions are connected each other in such a manner that the source electrode 6 covers the gate electrode through the insulating film, but they do not have to be connected.

In this manner, in the fourth process of forming the hetero semiconductor region 3 by patterning the hetero semiconductor layer 30 (see, FIG. 2F), the hetero semiconductor region 3 is formed by carrying out Chemical Mechanical Polishing (CMP) for the hetero semiconductor layer 30. With this, in the manufacturing processes of the structure of FIG. 1, as shown in FIG. 2G, the processes can be simplified since it is not needed to form a mask layer (not shown) having a predetermined opening in a predetermined region on the hetero semiconductor layer 30 by photolithography and etching. In addition, the surface of the element can be flat, accordingly problems regarding reliability such as disconnection can be suppressed.

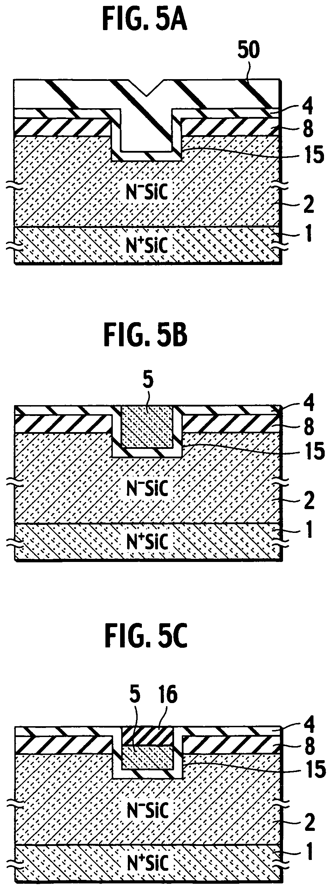

Next, referring now to FIGS. 5A to 5F, another manufacturing method according to the present embodiment will be described below. A completed structure is the same with that of FIG. 3.

First, FIGS. 2A to 2D showing the method of manufacturing the structure of FIG. 1 have the same structure with that of FIG. 1. In the structure shown in FIG. 2D, as shown in FIG. 5A, an insulating film 4 is deposited along an inner wall of an antioxidant film (mask layer) 8 and a drain region 2. Further, a polycrystalline silicon layer 50 to be a gate electrode 5 is deposited. After that, phosphorus is doped into the polycrystalline silicon layer 50 to be the gate electrode 5 by solid phase diffusion using POCl₃.

Next, the polycrystalline silicon layer 50 is etched back to be a state shown in FIG. 5B so that the gate electrode 5 is formed.

As shown in FIG. 5C, a cap oxide film 16 is formed in an upper portion of the gate electrode 5 by thermal oxidation.

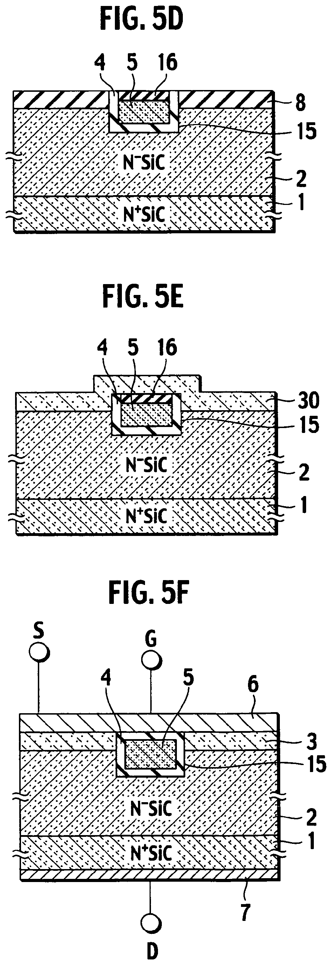

As shown in FIG. 5D, upper portions of the gate insulating film 4 and the cap oxide film 16 on the antioxidant film 8 are removed by dry etching.

As shown in FIG. 5E, the antioxidant film 8 formed of silicon nitride is removed by, for example, phosphoric acid solution before polycrystalline silicon is deposited by, for example, the LP-CVD method. After that, phosphorus doping is carried out in the atmosphere of, for example, POCl₃ so that a hetero semiconductor layer 30 formed of an N⁻type polycrystalline silicon is formed. It should be noted that this polycrystalline silicon layer may be formed by laser annealing to recrystallize it after being deposited by the electronic beam evaporation method or the sputtering method, or may be formed of single crystalline silicon of the hetero epitaxial growth by, for example, the molecular beam epitaxy. In addition, for the doping of the polycrystalline silicon layer, a combination of ionic implantation and activation heat treatment after the ionic implantation may be used.

Lastly, similar to the structure of FIG. 4, as shown in FIG. 5F, the hetero semiconductor region 3 is processed to be flat by Chemical Mechanical Polishing, a drain electrode 7 formed of, for example, titanium (Ti) and nickel (Ni) is formed on a substrate 1 corresponding to a backside surface of the semiconductor device, and a source electrode 6 is formed by sequentially depositing titanium (Ti) and aluminum (Al) in the hetero semiconductor region 3 corresponding to a front surface of the semiconductor device. Thus, the silicon carbide semiconductor device according to the structure of the embodiment shown in FIG. 3 is complete.

As described above, the present embodiment has a structure where, in a method of manufacturing the semiconductor device including the semiconductor body of a first conductivity type (the substrate 1 and the drain region 2), the hetero semiconductor region 3 adjacent to the one main surface of the semiconductor body and having a band gap different from that of the semiconductor body, the gate electrode 5 formed in the junction portion between the hetero semiconductor region 3 and the semiconductor body through the gate insulating film 4, the source electrode 6 connected to the hetero semiconductor region 3, and the drain electrode 7 having the ohmic connection with the semiconductor body, the method of manufacturing the semiconductor device includes at least a first process of forming the predetermined trench 15 on the main surface side of the semiconductor body by using the mask layer having a predetermined opening, a second process of forming the gate insulating film 4 so as to adjoin at least the side wall of the trench 15 , a third process of forming the gate electrode 5 adjacent to the gate insulating film 4, a fourth process of forming the hetero semiconductor layer 30 on the gate electrode 5 through the cap oxide film 16 which is an interlayer insulating film, and a fifth process of forming the hetero semiconductor region 3 by patterning the hetero semiconductor layer 30.

With this structure, the semiconductor device according to the present embodiment can be easily obtained with a conventional manufacturing technique. In addition, with this manufacturing method, a structure in which an upper end portion of the trench 15 of the drain region 2 with etching damages removed comes to be substantially flush with an end portion of the hetero semiconductor region 3 can be easily formed. With this, the gate electrode 5 can be formed through the gate insulating film 4 so as to oppose substantially perpendicular to the junction interface between the drain region 2 and the hetero semiconductor region 3. Therefore, an electric field effectively expands to the hetero junction interface depending on a voltage applied to the gate electrode 5 so that driving force during conduction is improved. In addition, by using a silicon nitride film as the antioxidant film 8, in the present embodiment in which the drain region 2 is formed of silicon carbide, the upper end portion of the trench 15 in the drain region 2 can be further easily formed to be substantially flush with the end portion of the hetero semiconductor region 3.

In addition, the gate insulating film 4 includes at least a thermal oxide film formed by thermal oxidation. With this, a quality gate insulating film can be easily formed so that improvement of driving force during the conducting state can be expected and high reliability can be obtained.

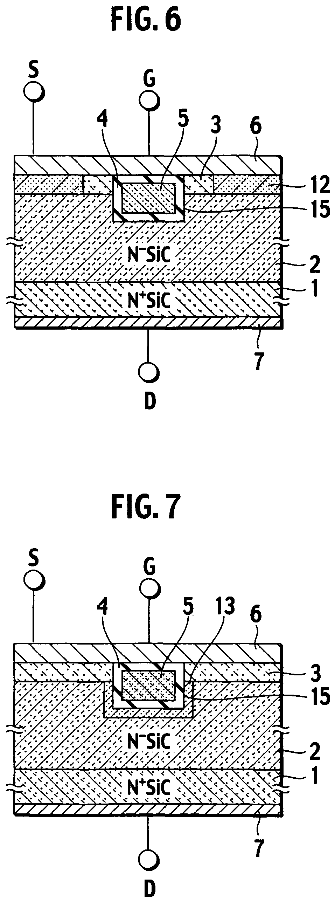

It should be noted that the technical teaching has been described by using the structures shown in FIGS. 1 and 3 as one example, but it can be applied to, for example, the structures shown in FIGS. 6 to 9.

A structure of FIG. 6 is different from that of FIG. 1 in that a hetero semiconductor region 3 formed of, for example, N⁻type polycrystalline silicon and a second hetero semiconductor region 12 formed of P⁻type polycrystalline silicon are formed so as to adjoin a main surface opposing to a junction surface between a drain region 2 and a substrate 1. That is, the junction portion of the drain 2, the hetero semiconductor region 3, and the second hetero semiconductor regions 12 has a hetero junction by materials having different band gap from that of SiC and polycrystal, and energy barriers are formed in the junction interface thereof. A gate insulating film 4 formed of, for example, a silicon oxide film is formed so as to adjoin the junction portion between the hetero semiconductor region 3 and the drain region 2. In addition, a gate electrode 5 is formed to be connected to the gate insulating film 4, a source electrode 6 is connected on an opposite surface opposing to the junction surface of the drain region 2 with the hetero semiconductor region 3 and the second hetero semiconductor region 12, and a drain electrode 7 is connected on the substrate 1.

In a method of manufacturing the structure of FIG. 6, the hetero semiconductor region 3 is formed before P⁻type impurity of reverse conductivity type that is, for example, a reverse conductivity type of the N⁻type hetero semiconductor region 3 is introduced into a predetermined portion (second hetero semiconductor regions 12) in the hetero semiconductor region 3. Thus, a conductivity type and impurity concentration of the hetero semiconductor region can be freely designed.

Next, operations of this structure will be described. In essence, the structure is similar to that of FIG. 1, but with such a structure, shielding performance will be further improved. It is because that an energy barrier for conduction electron is formed in both sides of the junction interface between the hetero semiconductor region 3 as well as the second hetero semiconductor region 12, and the drain region 2. In this time, both of the hetero semiconductor region 3 and the second hetero semiconductor region 12 are formed of a silicon material. Therefore, an energy barrier difference Δ Ec of each of them from the drain region 2 formed of silicon carbide comes to be substantially equal. However, the N⁻type hetero semiconductor region 3 and the P⁻type second hetero semiconductor region 12 have a difference in Fermi energy shown by energy from a conduction band to Fermi level. Therefore, a width of a depletion layer extended from the junction interface of the drain region 2 comes to be different. That is, the width of the depletion layer extended from the junction interface with the second hetero semiconductor region 12 is larger than the width of the depletion layer expanded from the junction interface with the hetero semiconductor region 3. Therefore, higher performance of shielding can be obtained, that is, leakage current can be reduced. Further, when, for example, the impurity concentration of the second hetero semiconductor region 12 is provided to be higher than that of the hetero semiconductor region 3, the depletion layer generated by built-in electric field of P-N diode formed of the second hetero semiconductor region 12 and the hetero semiconductor region 3 extends to the hetero semiconductor region 3 side. Therefore, the leakage current in the hetero junction between the hetero semiconductor region 3 and the drain region can be further reduced.

Further, in this structure, if the hetero semiconductor region 3 is designed to have a width with which the gate electric field reaches from the gate electrode 5, the shielding performance of the semiconductor device can be further increased when, for example, the gate electrode 5 is provided to be a negative potential, and a revere region is formed in, for example, an entire region of the hetero semiconductor region 3.

FIG. 7 is such that an N⁺ type conducting region 13 having higher concentration than that of a drain region 2 is formed in a predetermined portion between a gate insulating film 4 and the drain region 2 in the structure of FIG. 1. The description of a manufacturing method thereof will be given below as one example.

For example, in the state shown in FIG. 2D, the doping of phosphorus is carried out in the atmosphere of, for example, POCl₃ with a higher temperature, the phosphorus is introduced onto the surface of silicon carbide so that an N⁺ type conducting region 13 is formed. It should be noted that introduction of impurity with solid phase diffusion, or a method of introducing impurity with, for example, ionic implantation may be used.

With this structure, in a conducting state, an energy barrier of a hetero junction between the hetero semiconductor region 3 and the conducting region 13 are relieved, and majority carrier comes to easily flow from the hetero semiconductor region 3 to the drain region 2 through the conducting region 13. In addition, a higher conducting characteristic can be obtained and on resistance can be further reduced.

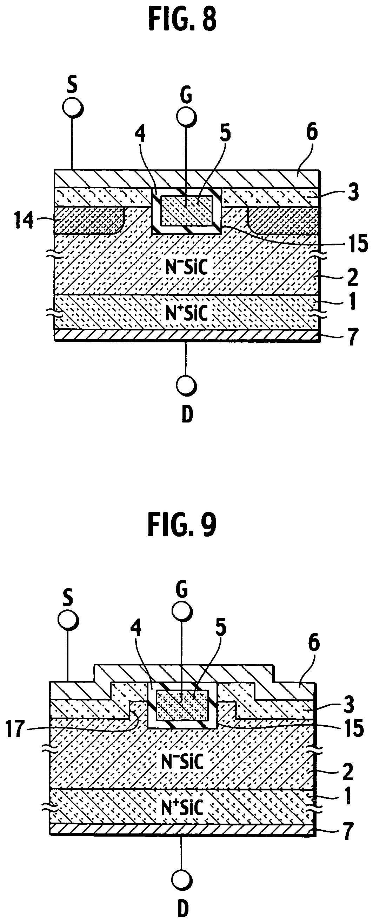

A structure of FIG. 8 is such that, in addition to the structure of FIG. 1, an electric field relaxation region 14 is formed on a surface of a drain region 2 so as to adjoin the hetero semiconductor region 3 and space apart a predetermined distance from a portion in which a gate electrode 5 and a hetero semiconductor region 3 are opposed each other. The description will be given below as one example.

In FIG. 2A having the structure of FIG. 1, for example, before the hetero semiconductor layer 30 is formed, the P type electric field relaxation region 14 is formed by the ionic implantation of aluminum ion or boron ion by using the mask layer having a predetermined opening as a mask. It should be noted that it may be formed by solid phase diffusion. The subsequent processes are the same with that of manufacturing the structure of FIG. 1.

With this structure, in a conducting state, the energy barrier of the hetero junction between the hetero semiconductor region 3 and the drain region 2 is relieved, and a higher conducting characteristic can be obtained. That is, on resistance further comes to be small, accordingly the conducting performance is improved.

In addition, in a shielding state, a depletion layer spreads between the electric filed relaxation region 14 and the drain region 2 depending on a drain potential. That is, the leakage current is further reduced and the shielding performance is improved since a drain potential applied to the hetero junction between the hetero semiconductor region 3 and the drain region 2 is relieved by the electric field relaxation region 14.

A structure of FIG. 9 is a modified example of the structure of FIG. 1, and a trench 17 is formed in the drain region 2 before the antioxidant film 8 is formed in FIG. 2A. After that, the hetero semiconductor layer 30 is formed. The sequent processes are the same with that of manufacturing the structure of FIG. 1. With this structure, the leakage current in the hetero semiconductor region 3 can be further reduced than the structure of FIG. 1.

As described above, using the basic processes of the embodiment, various structures as shown in FIGS. 6 to 9 can be formed.

As all the structures in the preferred embodiments are described so far taking, a semiconductor device using silicon carbide as a substrate material is described as one example, the material for the substrate may be other semiconductor materials such as silicon, silicon germanium, gallium nitride, and diamond. In addition, in all the structures, silicon carbide whose polytype is 4H is used as one example for the description, but it may be other polytype such as 6H and 3C. Moreover, in all the structures, a transistor having so-called a vertical structure in which a drain electrode 7 and a source electrode 6 are disposed to oppose each other with the drain region 2 sandwiched therebetween so that drain current flow occurs vertically, is used for the description, but a transistor having so-called a horizontal structure in which, for example, a drain electrode 7 and a source electrode 6 are disposed to be flush with each other so that drain current flow occurs horizontally, may be used.

Furthermore, the description is given by using polycrystal as a material used for a hetero semiconductor region 3 or a second hetero semiconductor region 12 as one example, but the material can be any material as long as it forms a hetero junction with silicon carbide. Still furthermore, as one example, the description is given by using an N⁻type silicon carbide as a drain region 2 and an N⁻type polycrystalline silicon as a hetero semiconductor region 3, but it may be any combination of N⁻type silicon carbide and P⁻type polycrystalline silicon, P⁻type silicon carbide and P⁻type polycrystalline silicon, and P⁻type silicon carbide and N⁻type polycrystalline silicon.

It is obvious that modifications may be made as long as it does not depart from the major point and the scope of the technical teaching.

It should be noted that a mask layer used for forming a predetermined trench on a main surface side of a semiconductor body according to claims of the present application corresponds to a mask layer 9 and an antioxidant film 8 in the preferred embodiments.

## Claims

1. A method of manufacturing a semiconductor device, said semiconductor device including a semiconductor body (1, 2) of a first conductivity type; a hetero semiconductor region (3) adjacent to one main surface of the semiconductor body (1, 2) and having a band gap different from that of the semiconductor body (1, 2); a gate electrode (5) formed in a junction portion between the hetero semiconductor region (3) and the semiconductor body (1, 2) through a gate insulating film (4); a source electrode (6) connected to the hetero semiconductor region (3); and a drain electrode (7) ohmic-connected to the semiconductor body (1, 2), the method comprising the steps of:
a first step of forming a trench (15) in a first mask layer (8) and in a surface layer portion of the semiconductor body (2) having an opening on said main surface side of the semiconductor body (1, 2) using a second mask layer (9);
a second step of forming a sacrificial oxide film (10) on the semiconductor body (1, 2), so as to remove damages of the previous step;
a third step of removing said sacrificial oxide film (10) from the semiconductor body (1, 2) by wet etching;
a fourth step of forming a buried region (11) adjacent to at least a side wall of the trench (15) being substantially flush with the upper portion of the trench (15);
a fifth step of forming a hetero semiconductor layer (30) so as to adjoin the semiconductor body (1, 2) and the buried region (11); and
a sixth step of forming the hetero semiconductor region (3) by patterning the hetero semiconductor layer (30).

2. A method of manufacturing a semiconductor device according to claim 1, wherein the hetero semiconductor region (3) is formed by etching back the hetero semiconductor layer (30) in the sixth step.

3. A method of manufacturing a semiconductor device according to claim 1, wherein the hetero semiconductor region (3) is formed by carrying out Chemical Mechanical Polishing for the hetero semiconductor layer (30).

4. A method of manufacturing a semiconductor device according to any one of claims 1 to 3, wherein the buried region (11) is formed of a material which is removed after the sixth step.

5. A method of manufacturing a semiconductor device according to any one of claims 1 to 4, wherein a step of forming the gate insulating film (4) so as to adjoin a hetero junction interface between the hetero semiconductor region (3) and the semiconductor body (1, 2) is included after the sixth step.

6. A method of manufacturing a semiconductor device, said semiconductor device including a semiconductor body (1, 2) of a first conductivity type; a hetero semiconductor region (3) adjacent to one main surface of the semiconductor body (1, 2) and having a band gap different from that of the semiconductor body (1, 2); a gate electrode (5) formed in a junction portion between the hetero semiconductor region (3) and the semiconductor body (1, 2) through a gate insulating film (4); a source electrode (6) connected to the hetero semiconductor region (3); and a drain electrode (7) ohmic-connected to the semiconductor body (1, 2), the method comprising the steps of:
a first step of forming a trench (15) in a first mask layer (8) and in a surface layer portion of the semiconductor body (2) having an opening on said main surface side of the semiconductor body (1, 2) using a second mask layer (9);
a second step of forming a sacrificial oxide film (10) on the semiconductor body (1, 2), so as to remove damages of the previous step;
a third step of removing said sacrificial oxide film (10) from the semiconductor body (1, 2) by wet etching;
a fourth step of forming the gate insulating film (4) adjacent to at least a side wall of the trench (15);
a fifth step of forming the gate electrode (5) adjacent to the gate insulating film (4);
a sixth step of forming a hetero semiconductor layer (30) on the semiconductor body (1, 2) and on an interlayer insulating film (16) which is formed in an upper portion of the gate electrode (5); and
a seventh step of forming the hetero semiconductor region (3) by patterning the hetero semiconductor layer (30).

7. A method of manufacturing a semiconductor device according to claim 6, wherein the gate insulating film (4) includes at least a thermal oxide film formed by thermal oxidation.

8. A method of manufacturing a semiconductor device according to any one of claims 1 to 7, wherein the semiconductor body (1, 2) is formed of silicon carbide.

9. A method of manufacturing a semiconductor device according to any one of claims 1 to 8, wherein the hetero semiconductor region (3) is formed of at least one of single crystalline silicon, polycrystalline silicon, and amorphous silicon.

10. A method of manufacturing a semiconductor device according to claim 8 or 9, wherein the first mask layer (8) is formed of a material having a thermal oxidation rate relative close to the thermal oxidation rate of silicon carbide.

## Patentansprüche

1. Verfahren zum Herstellen einer Halbleitervorrichtung, wobei die Halbleitervorrichtung einen Halbleiter-Körper (1, 2) eines ersten Leitfähigkeitstyps;
einen Hetero-Halbleiter-Bereich (3), der an eine Hauptfläche des Halbleiter-Körpers (1, 2) angrenzt und eine Bandlücke hat, die sich von der des Halbleiter-Körpers (1, 2) unterscheidet;
eine Gate-Elektrode (5), die in einem Übergangsabschnitt zwischen dem Hetero-Halbleiter-Bereich (3) und dem Halbleiter-Körper (1, 2) über einen Gate-Isolierfilm (4) ausgebildet ist;
eine Source-Elektrode (6), die mit dem Hetero-Halbleiter-Bereich (3) verbunden ist; und eine Drain-Elektrode (7) enthält, die in ohmscher Verbindung mit dem Halbleiter-Körper (1, 2) steht, wobei das Verfahren die folgenden Schritte umfasst:
einen ersten Schritt, in dem ein Graben (15) in einer ersten Maskenschicht (8) und in einem Oberflächenschicht-Abschnitt des Halbleiter-Körpers (2), der eine Öffnung an der Seite der Hauptfläche des Halbleiter-Körpers (1, 2) aufweist, unter Verwendung einer zweiten Maskenschicht (9) ausgebildet wird;
einen zweiten Schritt, in dem ein Opfer-Oxidfilm (10) an dem Halbleiter-Körper (1, 2) ausgebildet wird, um Schäden aus dem vorangehenden Schritt zu beseitigen;
einen dritten Schritt, in dem der Opfer-Oxidfilm (10) mittels Nassätzen von dem Halbleiter-Körper (1, 2) entfernt wird;
einen vierten Schritt, in dem ein vergrabener Bereich (11) an die wenigstens eine Seitenwand des Grabens (15) angrenzend ausgebildet wird, der im Wesentlichen bündig mit dem oberen Abschnitt des Grabens (15) ist;
einen fünften Schritt, in dem eine Hetero-Halbleiter-Schicht (30) so ausgebildet wird, dass sie an den Halbleiter-Körper (1, 2) und den vergrabenen Bereich (11) angrenzt; sowie
einen sechsten Schritt, in dem der Hetero-Halbleiter-Bereich (3) ausgebildet wird, indem die Hetero-Halbleiter-Schicht (30) strukturiert wird.

2. Verfahren zum Herstellen einer Halbleitervorrichtung nach Anspruch 1, wobei der Hetero-Halbleiter-Bereich (3) ausgebildet wird, indem in dem sechsten Schritt die Hetero-Halbleiter-Schicht (30) hinterätzt wird.

3. Verfahren zum Herstellen einer Halbleitervorrichtung nach Anspruch 1, wobei der Hetero-Halbleiter-Bereich (3) ausgebildet wird, indem chemisch-mechanisches Polieren für die Hetero-Halbleiter-Schicht (30) ausgeführt wird.

4. Verfahren zum Herstellen einer Halbleitervorrichtung nach einem der Ansprüche 1 bis 3, wobei der vergrabene Bereich (11) aus einem Material besteht, das nach dem sechsten Schritt entfernt ist.

5. Verfahren zum Herstellen einer Halbleitervorrichtung nach einem der Ansprüche 1 bis 4, wobei ein Schritt, in dem der Gate-Isolierfilm (4) so ausgebildet wird, dass er an eine Hetero-Übergangsgrenzfläche zwischen dem Hetero-Halbleiter-Bereich (3) und dem Halbleiter-Körper (1, 2) angrenzt, nach dem sechsten Schritt integriert wird.

6. Verfahren zum Herstellen einer Halbleitervorrichtung, wobei die Halbleitervorrichtung einen Halbleiter-Körper (1, 2) eines ersten Leitfähigkeitstyps;
einen Hetero-Halbleiter-Bereich (3), der an eine Hauptfläche des Halbleiter-Körpers (1, 2) angrenzt und eine Bandlücke aufweist, die sich von der des Halbleiter-Körpers (1, 2) unterscheidet;
eine Gate-Elektrode (5), die in einem Übergangsabschnitt zwischen dem Hetero-Halbleiter-Bereich (3) und dem Halbleiter-Körper (1, 2) über einen Gate-Isolierfilm (4) ausgebildet ist;
eine Source-Elektrode (6), die mit dem Hetero-Halbleiter-Bereich (3) verbunden ist; und
eine Drain-Elektrode (7) enthält, die in ohmscher Verbindung mit dem Halbleiter-Körper (1, 2) steht, wobei das Verfahren die folgenden Schritte umfasst:
einen ersten Schritt, in dem ein Graben (15) in einer ersten Maskenschicht (8) und in einem Oberflächenschicht-Abschnitt des Halbleiter-Körpers (2), der eine Öffnung an der Seite der Hauptfläche des Halbleiter-Körpers (1, 2) aufweist, unter Verwendung einer zweiten Maskenschicht (9) ausgebildet wird;
einen zweiten Schritt, in dem ein Opfer-Oxidfilm (10) an dem Halbleiter-Körper (1, 2) ausgebildet wird, um Schäden aus dem vorangehenden Schritt zu beseitigen;
einen dritten Schritt, in dem der Opfer-Oxidfilm (10) mittels Nassätzen von dem Halbleiter-Körper (1, 2) entfernt wird;
einen vierten Schritt, in dem der Gate-Isolierfilm (4) an wenigstens eine Seitenwand des Grabens (15) angrenzend ausgebildet wird,
einen fünften Schritt, in dem die Gate-Elektrode (5) an den Gate-Isolierfilm (4) angrenzend ausgebildet wird;
einen sechsten Schritt, in dem eine Hetero-Halbleiter-Schicht (3) an dem Halbleiter-Körper (1, 2) und an einem Zwischenschicht-Isolierfilm (16) ausgebildet wird, der in einem oberen Abschnitt der Gate-Elektrode (5) ausgebildet ist; und
einen siebten Schritt, in dem der Hetero-Halbleiter-Bereich (3) ausgebildet wird, indem die Hetero-Halbleiter-Schicht (30) strukturiert wird.

7. Verfahren zum Herstellen einer Halbleitervorrichtung nach Anspruch 6, wobei der Gate-Isolierfilm (4) wenigstens einen thermischen Oxidfilm enthält, der mittels thermischer Oxidation ausgebildet wird.

8. Verfahren zum Herstellen einer Halbleitervorrichtung nach einem der Ansprüche 1 bis 7, wobei der Halbleiter-Körper (1, 2) aus Siliziumkarbid ausgebildet wird.

9. Verfahren zum Herstellen einer Halbleitervorrichtung nach einem der Ansprüche 1 bis 8, wobei der Hetero-Halbleiter-Bereich (3) aus einkristallinem Silizium, polykristallinem Silizium oder/und amorphem Silizium ausgebildet wird.

10. Verfahren zum Herstellen einer Halbleitervorrichtung nach Anspruch 8 oder 9, wobei die erste Maskenschicht (8) aus einem Material ausgebildet wird, das eine Rate thermischer Oxidation hat, die relativ nahe an der Rate thermischer Oxidation von Siliziumkarbid liegt.

## Revendications

1. Procédé de fabrication d'un dispositif semi-conducteur, ledit dispositif semi-conducteur comprenant un corps semi-conducteur (1, 2) d'un premier type de conductivité ; une région hétéro semi-conductrice (3) adjacente à une surface principale du corps semi-conducteur (1, 2) et présentant un espace de bande différent de celui du corps semi-conducteur (1, 2) ; une électrode de grille (5) formée dans une partie de jonction entre la région hétéro semi-conductrice (3) et le corps semi-conducteur (1, 2) à travers un film d'isolation de grille (4) ; une électrode de source (6) connectée à la région hétéro semi-conductrice (3) ; et une électrode de drain (7) ohmiquement connectée au corps semi-conducteur (1, 2), le procédé comprenant les étapes de :
une première étape de formation d'une tranchée (15) dans une première couche formant masque (8) et dans une partie couche de surface du corps semi-conducteur (2) présentant une ouverture sur ledit côté de surface principale du corps semi-conducteur (1, 2) en utilisant une seconde couche formant masque (9) ;
une seconde étape de formation d'un film d'oxyde sacrificiel (10) sur le corps semi-conducteur (1, 2), afin de retirer les détériorations de l'étape précédente ;
une troisième étape d'élimination dudit film d'oxyde sacrificiel (10) depuis le corps semi-conducteur (1, 2) par gravure par voie humide ;
une quatrième étape de formation d'une région enfouie (11) adjacente à au moins une paroi latérale de la tranchée (15) affleurant sensiblement au niveau de la partie supérieure de la tranchée (15) ;
une cinquième étape de formation d'une couche hétéro semi-conductrice (30) afin de joindre le corps semi-conducteur (1, 2) et la région enfouie (11) ; et
une sixième étape de formation de la région hétéro semi-conductrice (3) en structurant la couche hétéro semi-conductrice (30).

2. Procédé de fabrication d'un dispositif semi-conducteur selon la revendication 1, la région hétéro semi-conductrice (3) étant formée par rétro-gravure de la couche hétéro semi-conductrice (30) dans la sixième étape.

3. Procédé de fabrication d'un dispositif semi-conducteur selon la revendication 1, la région hétéro semi-conductrice (3) étant formée en effectuant un polissage mécano-chimique pour la couche hétéro semi-conductrice (30).

4. Procédé de fabrication d'un dispositif semi-conducteur selon l'une quelconque des revendications 1 à 3, la région enfouie (11) étant formée d'un matériau qui est retiré après la sixième étape.

5. Procédé de fabrication d'un dispositif semi-conducteur selon l'une quelconque des revendications 1 à 4, dans lequel une étape de formation du film d'isolation de grille (4) afin d'adjoindre une interface d'hétérojonction entre la région hétéro semi-conductrice (3) et le corps semi-conducteur (1, 2) est introduite après la sixième étape.

6. Procédé de fabrication d'un dispositif semi-conducteur, ledit dispositif semi-conducteur comprenant un corps semi-conducteur (1, 2) d'un premier type de conductivité ; une région hétéro semi-conductrice (3) adjacente à une surface principale du corps semi-conducteur (1, 2) et présentant un espace de bande différent de celui du corps semi-conducteur (1, 2) ; une électrode de grille (5) formée dans une partie de jonction entre la région hétéro semi-conductrice (3) et le corps semi-conducteur (1, 2) à travers un film d'isolation de grille (4) ; une électrode de source (6) connectée à la région hétéro semi-conductrice (3) ; et une électrode de drain (7) ohmiquement connectée au corps semi-conducteur (1, 2), le procédé comprenant les étapes de :
une première étape de formation d'une tranchée (15) dans une première couche formant masque (8) et dans une partie couche de surface du corps semi-conducteur (2) présentant une ouverture sur ledit côté de surface principale du corps semi-conducteur (1, 2) en utilisant une seconde couche formant masque (9) ;
une seconde étape de formation d'un film d'oxyde sacrificiel (10) sur le corps semi-conducteur (1, 2), afin de retirer les détériorations de l'étape précédente ;
une troisième étape d'élimination dudit film d'oxyde sacrificiel (10) depuis le corps semi-conducteur (1, 2) par gravure par voie humide ;
une quatrième étape de formation du film d'isolation de grille (4) adjacent à au moins une paroi latérale de la tranchée (15) ;
une cinquième étape de formation de l'électrode de grille (5) adjacente au film d'isolation de grille (4) ;
une sixième étape de formation d'une couche hétéro semi-conductrice (30) sur le corps semi-conducteur (1, 2) et un film d'isolation d'inter-couche (16) qui est formé dans une partie supérieure de l'électrode de grille (5) ; et
une septième étape de formation de la région hétéro semi-conductrice (3) par structuration de la couche hétéro semi-conductrice (30).

7. Procédé de fabrication d'un dispositif semi-conducteur selon la revendication 6, le film d'isolation de grille (4) comprenant au moins un film d'oxyde thermique formé par oxydation thermique.

8. Procédé de fabrication d'un dispositif semi-conducteur selon l'une quelconque des revendications 1 à 7, le corps semi-conducteur (1, 2) étant formé de carbure de silicium.

9. Procédé de fabrication d'un dispositif semi-conducteur selon l'une quelconque des revendications 1 à 8, la région hétéro semi-conductrice (3) étant formée d'au moins l'un parmi le silicium monocristallin, le silicium polycristallin, et le silicium amorphe.

10. Procédé de fabrication d'un dispositif semi-conducteur selon la revendication 8 ou 9, la première couche formant masque (8) étant formée d'un matériau présentant un niveau d'oxydation thermique relativement proche du niveau d'oxydation thermique du carbure de silicium.
